# EUROPEAN PATENT SPECIFICATION

(11) **EP 3 829 059 B1**
(45) Date of publication and mention of the grant of the patent: **01.04.2026**
(21) Application number: 19212569.8
(22) Date of filing: 29.11.2019
(51) Int. Cl.: H03F 3/195, H03F 1/22, H03F 3/21, H03F 3/24, H03F 3/60

(54) **POWER COMBINER CIRCUIT AND METHOD**
LEISTUNGSKOMBINATIONSSCHALTUNG UND VERFAHREN
CIRCUIT ET PROCÉDÉ DE COMBINEUR DE PUISSANCE

(43) Date of publication of application: 02.06.2021
(73) Proprietor: Infineon Technologies AG, 85579 Neubiberg (DE)
(72) Inventor: SEEBACHER, David, 9500 Villach (AT); BASSI, Matteo, 9500 Villach (AT); PADOVAN, Fabio, 9500 Villach (AT)
(74) Representative: Kraus & Lederer PartGmbB

(56) References cited:
- WO-A1-2017/133776
- US-A- 4 743 859
- US-A1- 2007 152 751
- US-B2- 9 369 103
- MING-FONG LEI ET AL: "Design and Analysis of Stacked Power Amplifier in Series-Input and Series-Output Configuration", IEEE TRANSACTIONS ON MICROWAVE THEORY AND TECHNIQUES, PLENUM, USA, vol. 55, no. 12, 1 December 2007 (2007-12-01), pages 2802 - 2812, XP011196326, ISSN: 0018-9480, DOI: 10.1109/TMTT.2007.909147

## Description

### TECHNICAL FIELD

The present application relates to power combiner circuits, for example for radio frequency signals, and to corresponding methods.

### BACKGROUND

In applications like high frequency power amplifiers, a radio frequency input signal has to be amplified, level shifted to a higher voltage swing or both. Power combiner circuits essentially combine power from different transistors or transistor to an output. An achievable output power of such power combiner circuits may be limited by a supply voltage used and an ability to provide a sufficiently low output impedance while having acceptable losses. Depending on the implementation, at a certain point a loss caused by the power combining will outweight the gain in output power, which provides a limit to the peak output power that can be achieved in a certain technology.

Power combining may be done by parallel or series combining of cells comprising a transistor. Parallel combining at least in some implementations has a disadvantage of requiring large transformations down to low impedances, which may cause high losses. In series combining, source voltages of transistors may become high, causing breakdown of parasitic elements.

Another conventional approach is the use of multiple transistors combined with a series combiner, also known as distributed active transformer (DAT). This technique has the disadvantage of requiring an individual drive signal for each transistor used, which is difficult to generate and distribute in the proper phase.

A further approach to increase the output power of a power combiner circuit is stacking of transistors to increase the supply voltage which is transformed to an output voltage to a load. In this way, the load may be split in series among the transistors of the stack. In practice, possible stacking is limited to two or three transistors due to breakdown limits of the transistors.

US 4 743 859 A discloses a power combiner according to the preamble of claim 1 or 4.

WO 2017 / 133 776 A1 discloses a matrix power amplifier including a two-dimensional matrix of transistors that can be tuned to match the impedance of an antenna.

US 9 369 103 B2 discloses a multistage variable gain amplifier using transformers.

US 2007 / 0 152 751 A1 discloses a wide bandwidth radio frequency amplifier using transformers.

Ming-Fong Lei et al., "Design and Analysis of Stacked Power Amplifier in Series-Input and Series-Output Configuration", IEEE Transactions on microwave theory and techniques, Plenum, USA, Vol. 55 No. 12, December 2007, pp. 2802-2812 discloses a power combining technique using stacked devices.

### SUMMARY

A power combiner circuit as defined in claim 1 or 4 and a method as defined in claim 10 are provided. The dependent claims define further embodiments.

The above summary is merely intended to give a brief overview over some embodiments and is not to be construed as limiting, as other embodiments may include other features than the ones explicitly given above.

### BRIEF DESCRIPTION OF THE DRAWINGS

Fig. 1 is a block diagram of a power combiner circuit for illustrating some principles, but not constituting a claimed embodiment by itself.
Fig. 2 is a circuit diagram of a power combiner circuit according to an embodiment.
Fig. 3 illustrates example voltages in the power combiner circuit of Fig. 2.
Fig. 4 is a circuit diagram of a power combiner circuit according to a further embodiment.
Fig. 5 illustrates example voltages in the power combiner circuit of Fig.3.
Fig. 6 is a circuit diagram of a power combiner circuit according to a further embodiment.
Fig. 7 is a diagram illustrating example voltages in the power combiner circuit of Fig. 6.
Fig. 8 is a circuit diagram of a power combiner circuit according to a further embodiment.
Fig. 9 is a diagram illustrating example voltages in the power combiner circuit of Fig. 8.
Fig. 10 is a circuit diagram of a power combiner circuit according to a further embodiment.
Fig. 11 is a circuit diagram of a power combiner circuit according to a further embodiment.
Fig. 12 is a circuit diagram of a power combiner circuit according to a further embodiment.
Fig. 13 is circuit diagram of a power combiner circuit according to a further embodiment.
Fig. 14 is a circuit diagram of a power combiner circuit according to a comparative example not constituting a claimed embodiment.
Fig. 15 is a diagram illustrating voltages in the power combiner circuit of Fig. 14.
Fig. 16 is a flowchart illustrating a method according to an embodiment.

### DETAILED DESCRIPTION

In the following, various embodiments will be described in detail referring to the attached drawings. It is to be noted that these embodiments are given by way of example only and are not to be construed as limiting in any way.

For example, while an embodiment may be described comprising a plurality of features (elements, components, acts, events, etc.), in other embodiments some of these features may be omitted and/or may be replaced by alternative features. Furthermore, in addition to the features explicitly shown and described, additional features may be provided, for example features used in conventional power combiner circuits, level shifters or amplifiers like radio frequency amplifiers. Therefore, such conventional features may not be explicitly described.

Couplings or connections described herein refer to electrical couplings or connections unless noted otherwise. For example, inductive couplings are explicitly mentioned. Such couplings or connections may be modified as long as the general purpose of the coupling or connection, for example to transmit a certain kind of signal, voltage, current or power, is essentially maintained.

Variations and modifications described with respect to one of the embodiments may also be applied to other embodiments and will therefore not be described repeatedly. For example, to provide a better understanding, different implementation possibilities and variations of power converters are described in separate embodiments, although more than one of such modification and implementation possibilities may also be combined in a single embodiment.

Throughout the figures, like elements are denoted with the same reference numerals, and these elements will therefore not be described repeatedly.

While in embodiments discussed below, field effect transistors will be used as examples for transistors, in other embodiments also other types of transistors like bipolar transistors or insulated gate bipolar transistors (IGBTs) may be used.

Generically, a transistor may be described as comprising a control terminal and two load terminals. In case of a field effect transistor, the control terminal is the gate terminal, and the load terminals are the source and drain terminals. In case of a bipolar transistor, the control terminal is the base terminal, and the load terminals are the collector and emitter terminals. In case of an insulated gate bipolar transistor, the control terminal is the gate terminal, and the load terminals are the collector and emitter terminals.

Some embodiments relate to power combiners for radio frequency (RF) signals. The term radio frequency may relate to signals having a frequency greater than one MHz, for example greater than 100 MHz or in the GHz range. For example, the upcoming fifth generation (5G) mobile communication standard uses a first frequency range between 600 MHz and 6 GHz and a second frequency range above 24 GHz, for example up to 40 GHz, up to 60 GHz or up to 80 GHz.

In embodiments, a power combiner circuit comprises a plurality of cells, each cell comprising one or more transistors. The power combiner circuit may be configured such that in operation, each cell but the last cell gives a part of its output power to an output of the power combiner circuit, for example to a load, while another part of the power is provided to a following cell, providing the same. The providing of powers may be done via inductive couplings. Examples for such techniques will now be discussed referring to the drawings.

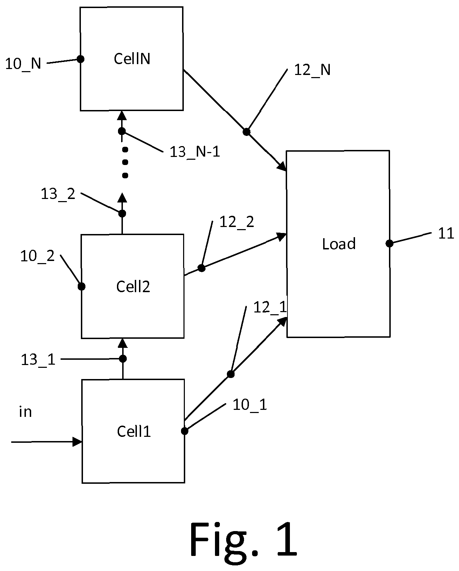

Turning now to the figures, Fig. 1 shows a block diagram of a power combiner circuit to illustrate principles used in embodiments, but not constituting a claimed embodiment by itself, which serves to output power to a load 11 based on an input signal in.

The power combiner circuit of Fig. 1 comprises n cells 10, where n is an integer number greater than 1 (i.e. at least 2). The individual cells are denoted with numerals 10_1, 10_2...10_N in Fig. 1 and will be collectively referred to as cells 10.

In embodiments, each cell comprises one or more transistors. In some embodiments, cells number 2 (cell 10_2) to the penultimate cell (cell 10_N-1) are implemented in the same manner.

Cell 10_1 receives input signal in, for example at a control input (gate or base) of a transistor thereof.

Each cell but the last cell (i.e. cell 10_1 to cell 10_N-1) provides part of its output power to a load 11, as indicated by arrows 12_1, 12_2.... Cell 10_N provides its complete output power to load 11, as indicated by an arrow 12_N. It should be noted that terms like "complete output power" or also a division of the output power as explained below is to be understood as comprising losses which always may happen in real implementations of systems.

Furthermore, all cells but the last cell provide another part of their output power to the respective next cell (cell 1 to cell 2, cell 2 to cell 3, etc.), as indicated by arrows 13_1, 13_2...13_N-1. In these way, only one control signal is needed for the first cell, and the subsequent cells are controlled by the respective power provided to them by the preceding cell. Moreover, by the partitioning of the output power between the load and the subsequent cell, as will be explained later in some implementations, some problems which exist in conventional solutions may be overcome. For example, increasing source voltages at transistors in a conventional series connection may be avoided, and on the other hand, many transistors for power combination without the problems of stacked transistors experiencing a breakdown may be used. The number of cells is not particularly limited, and any number n of cells may be used. For example, up to 5 cells, up to 10 cells, up to 20 cells, up to 50 cells or even more cells may be used.

The providing of partial power as indicated by arrows 12_1 to 12_N and 13_1 to 13_N-1 may be implemented using inductive couplings e.g. using transformers or inductively coupled lines between the cells and the load. Other couplings that provide DC decoupling and allow for a combining of power e.g. by a series connection on a side of load 11 may be used. For providing power to the respective next cell, any matching/splitting network may be used.

It should be noted that the part of the power provided to the respective next cell may be smaller than the power provided to the load (for example the power provided according to arrow 13_1 may be smaller than the power provided according to arrow 12_1 for cell 10_1). In some embodiments, the power provided to the respective next cell is at least 5%, at least 10% or at least 20% of the total output power of the respective cell. In some embodiments, the power provided to the load is at least 30%, at least 40% or at least 50% of the total output power of the respective cell. The power provided to the respective next cell according to arrows 13 needs only be sufficient such that the respective next cell behave in accordance with the input signal in. In some other implementations an equal power split may be used in order to facilitate a simple implementation.

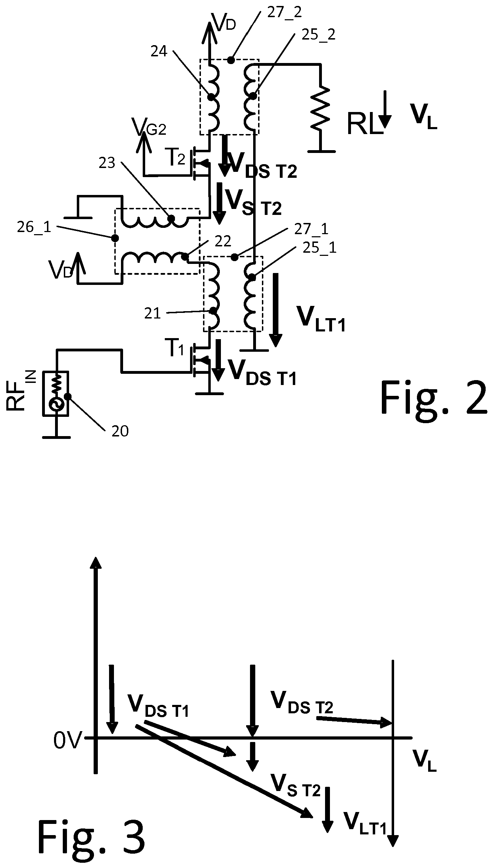

For further illustration of the concept described with reference to Fig. 1, various implementation possibilities will now be described referring to Fig. 2 to Fig. 12.

Fig. 2 is a circuit diagram of a power combiner circuit according to an embodiment. In the example of Fig. 2, the power combiner circuit comprises two cells, each cell comprising one transistor.

A first cell in Fig. 2 comprises a transistor T₁, a second primary side 22 and a first primary side 21. A second cell comprises a transistor T₂, a second secondary side 23 and a first primary side 24. The power combiner circuit of Fig. 2 serves to provide power to a load RL coupled to a load output terminal of the power combiner circuit, which in Fig. 2 is symbolized by a resistor. It is to be understood that depending on the load, a load may comprise resistive, inductive and/or capacitive components. In particular, the type of load is not particularly limited, and the depicted resistor serves only as a simple example. As shown in Fig. 2, first secondary sides 25_1, 25_2 may be coupled in series with load RL and a load output terminal of the power combiner circuit may be a node between first secondary side 25_2 and load RL. A part of the power combiner circuit electrically coupled to the load, in this case first secondary sides 25_1, 25_2, may also be referred to as load output circuit herein.

Second primary side 22 and second secondary side 23 form a transformer 26_1, first primary side 21 and first secondary side 25_1 form a transformer 27_1 and first primary side 24 and first secondary side 25_2 form a transformer 27_2. Each transformer 26_1, 27_1, 27_2 may comprise inductors on the respective primary and secondary side including series inductors, parallel inductors, parasitic inductors etc. and/or may comprise further components, for example for impedance matching, and/or components for transmitting signals like RF signals.

It shall be noted that there may be additional matching and or transformation of the load impedance to match to any type of load.

The first cell receives a radio frequency input signal RF_{IN} from a radio frequency source 20 at a gate terminal of transistor T₁. Radio frequency source 20 may be any circuitry generating a radio frequency signal, for example circuitry in a mobile telecommunication application.

Both cells are supplied by a supply voltage V_{D} at drain terminals of transistors T₁, T₂, respectively, with respect to ground.

Transistor T₁ acts as amplifier transistor of the first cell. Part of the power thus generated is transferred to the load by transformer 25_1. Another part of the power generated is transferred to the second cell through transformer 26_1.

Transistor T₂ of the second cell is biased by a gate voltage V_{G2} to provide an adequate bias current similar to T₁. The gate voltage V_{G2} may be variable. In some implementations, a DC part of the gate voltage V_{G2} may be fixed. In some embodiments, a radio frequency (RF) network may be provided, for example implemented by a capacitive divider, which allows some voltage swing. The power generated by transistor T₂ is provided to load RL through transformer 27_2.

The terminology regarding primary sides, secondary sides and transformers used in the explanation of Fig. 2 above will also be used for the embodiments described below and will be summarized here, assuming N cells.
- For a cell number i, i=1...N-1, a transformer 26_i is used to provide a part of the power to the respective i+1-th cell (transformer 26_1 in Fig. 2). This transformer 26_i comprises a second primary side (e.g. 22), e.g. in the i-th cell and a second secondary side (e.g. 23), e.g. in the second cell.
- For a cell number i, i=1...N, a transformer 27_i is used to provide a part of the output power to the load (transformers 27_1, 27_2 in Fig. 2). Each transformer 27_i comprises a first primary side (e.g. 21, 24 in Fig. 2) and a first secondary side (e.g. 25_1, 25_2).
- Generally, in operation power is transferred from the primary side to the secondary side.

As already briefly explained with respect to Fig. 1, the part of the output power of transistor T₁ transferred to the second cell via transformer 26_1 may be smaller than the part of the power provided directly to the load RL through transformer 27_1. In particular, the power provided to the second cell in some implementations need only be large enough to ensure a corresponding control of transistor T₂ by its gate source voltage.

In particular, the ratio of the powers provided may be adjusted by designing the transformers 26_1, 27_1 accordingly. Moreover, an appropriate source voltage for transistor T₂ may be adjusted by adjusting a turn ratio of transformer 26_1 accordingly.

In Fig. 2, a drain source voltage of transistor T₁, V_{DS T1}, a voltage across inductor 25_1, V_{LT1}, a voltage across a drain source voltage of transistor T₂, V_{DS T2}, a source voltage of transistor T₂, V_{s T2}, and a voltage across the load V_{L} are denoted by arrows. Using these voltage, operation of the embodiment of Fig. 2 will be schematically explained with respect to Fig. **3****.**

Essentially, as illustrated in Fig. 3, the drain source voltage V_{DS T1} of transistor T₁ causes the voltage V_{LT1} (coupling of part of the power via transformer 27_1) and causes the source voltage V_{s T2} via transformer 26_1.

As can be seen, a comparatively high load voltage V_{L} is built up in this way by combining the voltage V_{LT1} at first secondary side 25_1 with the corresponding voltage at first secondary side 25_2 compared to the drain source voltages of the individual transistors, thus combining the power of the transistors and causing a level shifting.

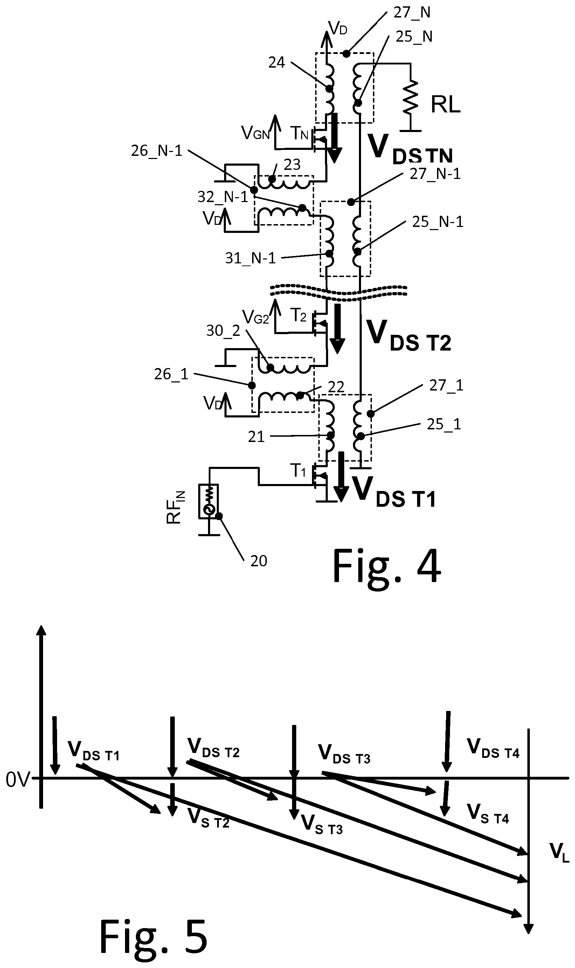

The approach shown for two cells in Fig. 2 may be extended to N cells, which is shown in Fig. 4.

In Fig. 4, between a first cell which is configured as in Fig. 2 and comprises transistor T₁, second primary side 22 and first primary side 21 already described, and the N-th cell which is configured corresponding to the second cell of Fig. 2 and comprises transistor T_{N} (corresponding to transistor T₂ of Fig. 2), second secondary side 23 and first primary side 24 already described, N-2 intermediate cells are inserted in series. Each intermediate cell comprises a second secondary side 30, of which second secondary side 30_2 is shown for the second cell, a transistor, of which transistor T₂ is shown for the second cell, second primary side 32, of which a second primary side 32_N-1 is shown for the N-1-th cell and a first primary side 31, of which first primary side 31_N-1 is shown for the N-1-th cell. As can further be seen in Fig. 4, for each cell, a respective first secondary side 25 (25_1 to 25_n) is provided coupled to load RL.

The primary and secondary sides form transformers 26_1 to 26_N-1 and 27_1 to 27_N as defined in the general explanation of the terminology above.

Each i-th intermediate cell, i=2...N-1, receives power from the preceding cell via transformer 26_i-1. A part of the power generated by the transistor of the i-th intermediate cell is output to the load RL via the respective transformer 27_i. Furthermore, a part of the power generated in the i-th intermediate cell is provided to a respective next cell via transformer 26_i.

The transistors of the second to N-th cells are biased by respective gate voltage V_{G2}...V_{GN} which may be equal to each other but which also may be unequal to each other and tailored to the respective source voltage received from the preceding cell. The explanations for gate voltage V_{G2} of Fig. 2 also apply to these gate voltages.

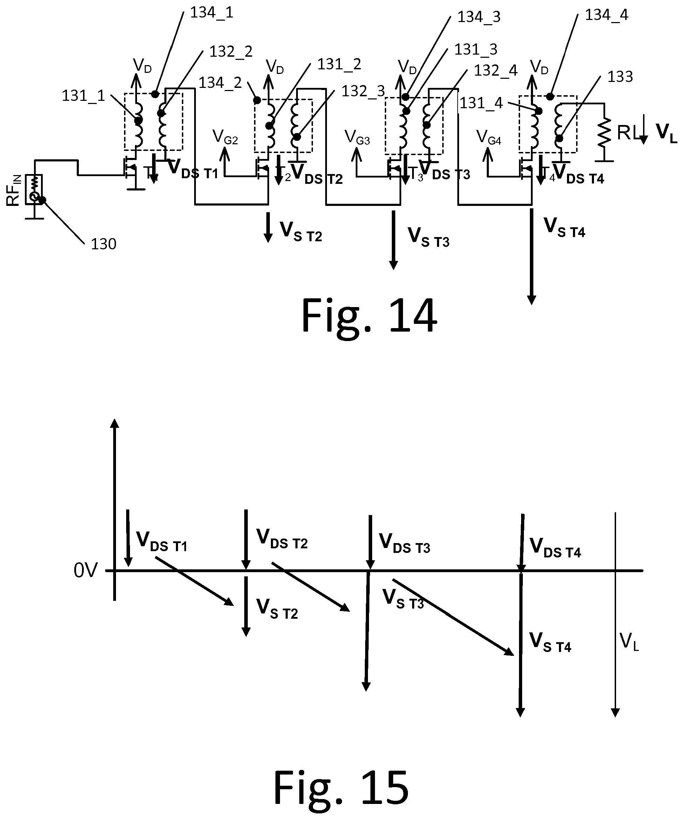

In Fig. 4, drain source voltages of the transistors T₁, T₂...T_{N} are marked by arrows and labeled V_{DS T1}, V_{DS T2} ...V_{DS TN}. These voltages and respective source voltages of the transistors from the second to N-th cells are illustrated in Fig. 5 for a case N=4 together with a load voltage V_{L}. As can be seen, part of the drain source voltage of each transistor contributes to the load voltage V_{L}, and another, for example smaller, part generates the source voltage Vₛ for the transistor of the respective next cells. As illustrated in Fig. 5, the source voltages of transistors T₂, T₃, and T₄ thus generated may be approximately the same. This is unlike a conventional case, where in a series connections source voltages are built up. To further illustrate this, Fig. 14 illustrates a comparative example not constituting a claimed embodiment.

In particular, Fig. 14 shows a comparative example of a series connections of cells without coupling of power from each cell to a load, which is done in the embodiment of Fig. 4. Fig. 14 illustrates an example with four cells.

Each cell comprises a transistor, labeled T₁ to T₄. Transistor T₁ of the first cell receives a radio frequency input signal RF_{IN} from a radio frequency source 130.

Each of the first to fourth cell (comprising transistor T₁ to T₄) comprises a respective primary side 131 (labeled 131_1 to 131_4). Each of the second to fourth cell furthermore comprises a secondary side 132 (132_2 to 132_4) to form transistors 134_1 to 134_3 to receive power from the preceding cell. Primary sides 131 are coupled to the drain terminals of the transistors of the respective cell, and secondary sides 132 are coupled to the source terminals. Transistors T₂ to T₄ are biased by respective gate voltages V_{G2} to V_{G4}, which are adapted to the respective source voltages received to ensure a corresponding control of the transistors. The load receives power from the fourth cell through a transformer 134_4 including a secondary side 133 and a primary side 131_4.

In Fig. 14, furthermore, the drain source voltages of transistors T₁ to T₄ (V_{DS T1} to V_{DS T4)}) and the source voltages of transistors T₂ to T₄ (V_{S T2} to V_{S T4}) are indicated.

In the power combiner circuit of Fig. 14, apart from inherent losses the complete power of a cell is provided to the respective next cell, by providing essentially a drain source voltage of a cell to the source of a transistor of a respective next cell. As further illustrated in Fig. 15, this leads to an increase of the source voltage from stage to stage. Such high source voltages at some point may trigger parasitic source-bulk diodes or other parasitic elements, causing a malfunctioning of the power combiner and/or limiting the number of stages. Compared thereto, in implementations according to techniques discussed herein where part of the power is provided to a respective next cell and another part of the power is provided directly to the load, the source voltages may be limited, and a breakdown involving such parasitics may be avoided in some implementations, as illustrated in Figs. 4 and 5.

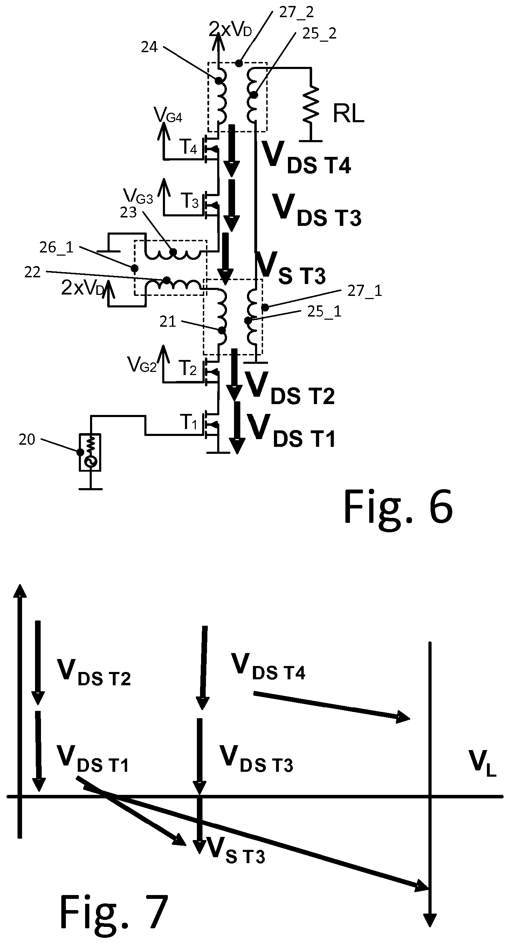

Next, variations and modifications of the embodiments shown in Fig. 2 and Fig. 4 will be discussed referring to Fig. 6 to Fig. 13. As mentioned previously, while different modifications will be discussed using different figures for ease of understandings, two or more of these modifications may also be combined with each other in other embodiments.

As the embodiments described in the following are variations of the embodiments described with respect to Fig. 2 to Fig. 5, like elements bear the same reference numerals and will not be described repeatedly. Instead, the differences, modifications or additions compared to the embodiments of Fig. 2 to Fig. 5 will be discussed in detail.

Fig. 6 shows a circuit diagram of a power combiner circuit according to a further embodiment, which is based on the embodiment of Fig. **2****.** Instead of providing one transistor in each cell, in Fig. 2 two stacked transistors are provided in each cell, T₁ and T₂ for the first cell and T₃ and T₄ for the second cell.

As mentioned in the introductory portion, stacking of transistors is a per se conventional technique for power combining, but the number of transistors that may be stacked in current transistor implementations is limited to two or three transistors due to breakdown considerations. In the embodiment of Fig. 6, this stacking of two transistors is combined with the techniques of Fig. 2, and the power transfer between the cells and to the load correspond to the ones discussed with reference to Fig. **2****.** As each cell now comprises two transistors, each cell may be biased with twice the voltage V_{D} of Fig. 2, denoted with 2xV_{D} in Fig. **6****.**

Transistor T₁ of the first cell is coupled to RF signal source 20, whereas the second transistor T₂ of the first cell and the transistors T₃, T₄ of the second cell are biased by respective gate voltages V_{G2}, V_{G3} and V_{G4}, respectively. Regarding the choice of these gate voltages, essentially the same considerations as already discussed with respect to Fig. 2 apply.

In Fig. 6, the drain source voltages of transistors T₁ to T₄ (V_{DS T1} to V_{DS T4}) are marked as well as the source voltage of transistor T₃ (V_{S T3}), which receives its source voltage from the first cell. Fig. 7 shows the voltages in a diagram similar to the diagram of Fig. 3. Also here, an increased load voltage V_{L} may be obtained compared to the drain source voltages of the individual transistors. Moreover, by using cells coupled in series in the way shown, the limit for transistor stacking mentioned above may be circumvented, by providing only two or for example also three stacked transistors in each cell. Generally, the number of transistors in each cell are limited essentially by the breakdown voltage of the transistors, which depends on the implementation.

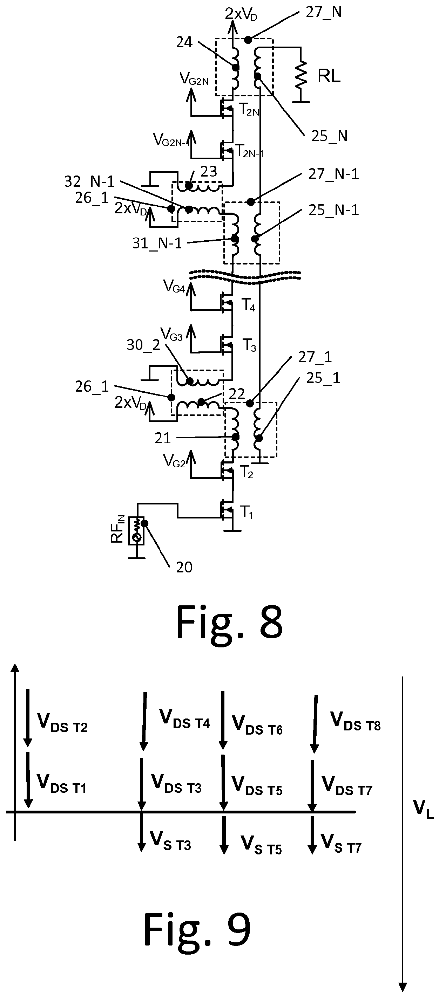

Using stacked transistor in each cell may also be extended to more than two cells. A corresponding embodiment of a combiner circuit is illustrated in Fig. 8.

The embodiment of Fig. 8 is based on the embodiment of Fig. 4, and again like elements are designated with the same reference numerals. In contrast to the embodiment of Fig. 4, in the embodiment of Fig. 8 each cell has two stacked transistors (T₁ and T₂ for the first cell, T₃ and T₄ for the second cell... etc., up to T_{2N-1} and T_{2N} for the N-th cell. Transistor T₁ receives the radio frequency input signal RF_{IN} at a gate terminal thereof, whereas the other transistors are biased by respective gate voltages V_{G2} to V_{G2N}. Similar to the embodiment of Fig. 6, also in Fig. 8 the individual cells are biased with a voltage 2xV_{D}. Apart from the stacking of the transistors and related biasing, the embodiment of Fig. 8 corresponds to the embodiment of Fig. 4.

Fig. 9 shows drain source voltages and source voltages for the embodiment of Fig. 8 for four cells (similar to Fig. 5), i.e. N=4. Drain source voltages of transistors T₁ to T₈ as well as source voltages of transistors T₃, T₅ and T₇, i.e. the transistors which receive their source voltage from the respective preceding cell, are shown. As can be seen, also in this case a strong increase of the source voltages from stage to stage, as in the comparative example of Fig. 14 and Fig. 15, may be avoided, and a comparatively large load voltage V_{L} may be built up.

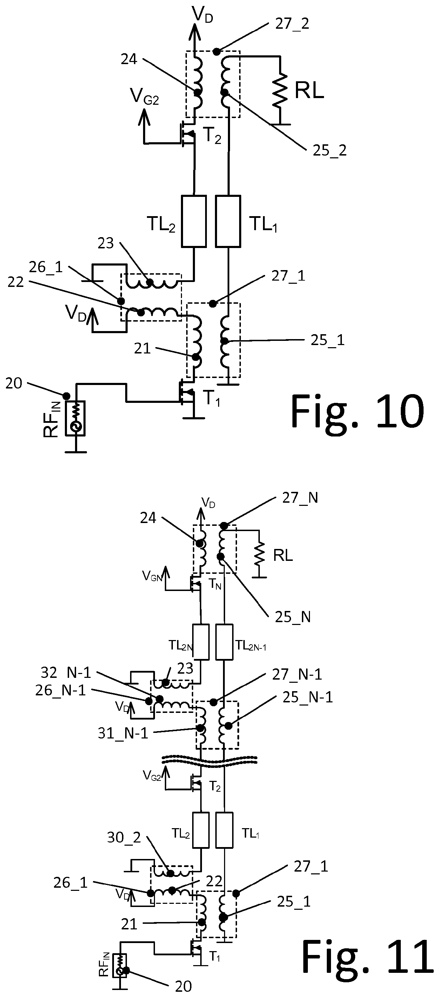

In some cases, it may be desirable to have a flexible layout of the cells, such that for example inductors may be placed appropriately on a chip. In some embodiments, transmission lines may be used to couple different parts of cells. Transmission lines are generally devices capable of transmitting radio frequency signals and may be implemented for example as so called microstrips or strip lines. Fig. 10 shows a combiner circuit according to an embodiment based on the embodiment of Fig. 2, and Fig. 11 shows a combiner circuit according to an embodiment based on the embodiment of Fig. 4, where transmission lines are used to increase layout flexibility. For example, in the embodiment of Fig. 10, a transmission line TL₁ between first secondary sides 25_1 and 25_2 and a transmission line TL₂ between second secondary side 23 and transistor T₂ are used. In other embodiments, other placements of transmission lines are possible, for example between transistor T₂ and inductor 24.

The embodiment of Fig. 11 extends this concept to N cells, where corresponding transmission lines TL₁, TL₂...TL_{2N-1}, TL_{2N-2} may be used. It should be noted that in yet other embodiments, transmission lines may be used only within some of the cells, whereas other cells may not have transmission lines.

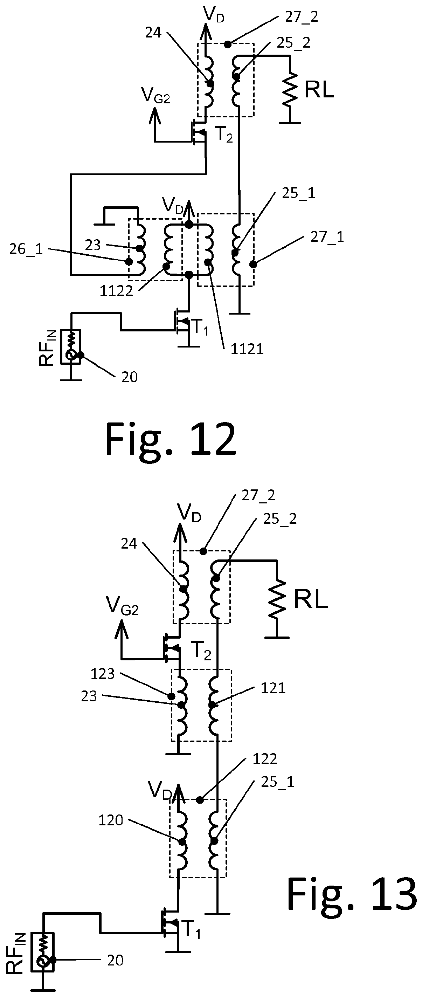

In the embodiments discussed so far, primary sides coupled in series (for example primary sides 21, 22 or 31, 32) are used to couple parts of a power of a cell directly to the load and another part to a next cell via the respective transformers including the primary sides. Other configurations are also possible. For example, Fig. 12 illustrates an embodiment based on the embodiment of Fig. 2, where primary sides 21, 22 coupled in series are replaced by a second primary side 1122 and a first primary side 1121 coupled in parallel. A first primary side 1121 and a first secondary side 25_1 form transformer 27_1 to couple part of the power of the first cell to the load, and a second primary side 1122 and second secondary side 23 form transformer 26_1 to couple another part of the power to the second cell. This concept may be extended to more than one cell, for example also used in the embodiment of Fig. 4. It should be noted that also mixed implementations are possible, where some cells use series coupling of primary sides and other cells use parallel couplings of primary sides.

It should also be noted that the combination of transformers 26_1 and 27_1 may be replaced by a trifilar transformer in other embodiments.

In some embodiments, the circuit of Fig. 12 may provide a lower load impedance which may help to increase output power.

In the embodiments described above, part of the power is provided from one cell to the next via a direct inductive coupling. In other embodiments, an indirect coupling may be used. A power combiner circuit according to a corresponding embodiment is illustrated in Fig. 13.

In Fig. 13, an example with two cells is shown, which again is a modification of the embodiment of Fig. 2 is. The variations illustrated with respect to Fig. 13 may also be applied to embodiments including more than two cells.

In the embodiment of Fig. 13, the first cell including transistor T₁ includes only a single primary side 120, for coupling the power generated by T₁ to secondary side 25_1, which is coupled to load RL, via a transformer 122. Therefore, in this case, the complete output power is coupled to the load output circuit. A primary side 121 of the load output circuit is electrically coupled in series to inductor 25_1 and forms a transformer 123 with second secondary side 23 of the second cell, such that part of the power coupled from the first cell to the load output circuit is then provided from the load output circuit to the second cell. In this case, therefore, the coupling is not directly from the first cell to the second cell, but via a line including first secondary sides 25_1, and 25_2 and primary side 121 coupled to the load RL and therefore an indirect coupling. In embodiments, first secondary sides 25 and primary side 121 (more than one for more than two cells) may be arranged in an alternating manner.

The embodiment of Fig. 13 may help to decrease the complexity of the interconnects, as the cells do not have to be placed next to each other for a direct inductive coupling, but merely the electrical connection including first secondary sides 25_1, 25_2 and primary side 121 which is then coupled to the load RL is used to provide the connections and couplings.

Therefore, various ways of coupling part of the power from a cell to a load and another part to a next cell exist, and embodiments are not limited to any specific techniques.

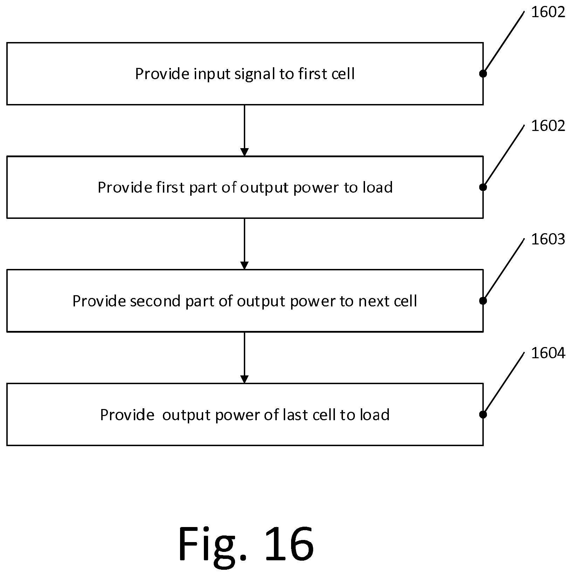

Fig. 16 is a flowchart illustrating a method according to an embodiment. The method of Fig. 16 is implemented using any of the embodiments discussed above and, to avoid repetitions, will be described referring to these embodiments.

While the method is represented as a series of acts or events, the order shown and described is not to be construed as limiting. For example, acts or events may be performed essentially in parallel in different parts of a circuit or may be performed continuously.

The method uses N cells, like cells 10 of Fig. 1. At 1601, the method comprises receiving an input signal, for example a radio frequency input signal like signal RF_{IN} mentioned above, at a first cell of the N cells.

For each i-th cell, i=1...N-1, the method comprises, at 1602, providing a first part of an output power of the i-th cell to a load (e.g. as represented by arrows 12_1, 12_2 in Fig. 1), and, at 1603, providing a second part of the output power to a respective next cell, i.e. i+1-th cell (e.g. as represented by arrows 13 in Fig. 1).

At 1604, the method comprises providing the output power of a last cell (i.e. N-th cell) to a load (e.g. as per arrow 12_N in Fig. 1).

The various possibilities for cell design (e.g. using stacked transistors or single transistors, using transmission lines etc.) and for providing power (e.g. using transformers 26, 27) may also be applied to the method.

## Claims

1. A power combiner circuit, comprising:
N cells (10), where N is an integer number greater than 1,
each cell of the N cells comprising at least one transistor (T₁...T_{N}), wherein a first cell (10_1) of the N cells (10) is configured to receive an input signal (RF_{IN}), wherein each cell different from the N-th cell is configured to provide a first part of its output power to a load output terminal of the power combiner circuit and a second part of its output power to a respective next cell, wherein the second part is equal to or less than the first part, and wherein the N-th cell (10_N) of the N cells (10) is configured to provide its output power to the load output terminal,
**characterized in that**
each cell different from the N-th cell comprises a first primary side (21; 31) of a first transformer (27) for outcoupling the first part of the output power and a second primary side (22; 32) of a second transformer (26) for outcoupling the second part of the output power, wherein each cell different from the first cell comprises a second secondary side (23; 30) of a respective second transformer (26) for receiving the second part of the output power from the preceding cell, wherein the N-th cell includes a first primary side (24) of a first transformer (27) for outcoupling the power from the N-th cell, wherein the power combiner circuit further comprises N first secondary sides (25) of respective ones of the first transformers (27) coupled in series to the load output terminal,
wherein the first cell (10_1) is configured to receive the input signal at a control terminal of a first transistor (T₁) of the at least one transistor of the first cell, wherein a load terminal of the first transistor (T₁) of the at least one transistor of the first cell (10_1) is coupled to the first primary side (21) of the first transformer (27) of the first cell (10_1) and to the second primary side (22) of the second transformer (26) of the first cell (10_1), wherein, for each cell different from the first cell a first load terminal of the at least one transistor (T₂...T_{N}) is coupled to the respective second secondary side (23; 30) of the respective cell, a control terminal of the at least one transistor (T₂...T_{N}) is configured to be coupled to a bias voltage and a second load terminal of the at least one transistor (T₂...T_{N}) is coupled to the respective first primary side of the respective cell, and for each cell different from the first cell and the N-th cell the second load terminal of the at least one transistor (T₂...T_{N-1}) is further coupled to the respective second primary side of the respective cell (102...10_N-1).

2. The power combiner circuit of claim 1, wherein the first and second primary sides of at least some of the cells different from the N-th cell are connected in series.

3. The power combiner circuit of claim 1 or 2, wherein the first and second primary sides of at least some of the cells different from the N-th cell are connected in parallel.

4. A power combiner circuit, comprising:
N cells (10), where N is an integer number greater than 1,
each cell of the N cells comprising at least one transistor (T₁...T_{N}), wherein a first cell (10_1) of the N cells (10) is configured to receive an input signal (RF_{IN}), wherein each cell different from the N-th cell is configured to provide a first part of its output power to a load output terminal of the power combiner circuit and a second part of its output power to a respective next cell,
wherein the second part is equal to or less than the first part, and wherein the N-th cell (10_N) of the N cells (10) is configured to provide its output power to the load output terminal,
**characterized in that**
each cell of the first to N-th cell comprises a primary side (120; 24) of a respective first transformer (122, 27_2) configured to outcouple the output power to a load output circuit (25_1, 121, 25_2) coupled to the load output,
wherein each cell different from the first cell comprises a secondary side (23) of a respective second transformer (123) to receive the respective second part of the power from the preceding cell, wherein the load output circuit comprises N secondary sides (25_1, 25_2) of the respective first transformers coupled in series in an alternating manner with N-1 primary sides (121) of the respective second transformers (123), wherein the first cell (10_1) is configured to receive the input signal at a control terminal of a first transistor (T₁) of the at least one transistor of the first cell, wherein a second load terminal of the first transistor (T₁) of the at least one transistor of the first cell (10_1) to N-th cell (10_N) is coupled to the first primary side (120; 24) of the respective cell (10_1...10N), wherein the control terminal of the at least one transistor of each cell different from the first cell is configured to be coupled to a bias voltage,
wherein a first load terminal of the at least one transistor of each cell different from the first cell is coupled to the secondary side (23) of the respective cell.

5. The power combiner circuit of any one of claims 1 to 4, wherein each cell different from the first cell is configured to receive the second part of the power from the respective previous cells at a first load terminal of a first transistor (T₁...T_{N}) of the at least one transistor of the respective cell, and to provide the first and second parts of the power at a second load terminal of the first transistor (T₂...T_{N}) or a further transistor of the at least one transistor of the respective cell.

6. The power combiner circuit of any one of claims 1 to 5, wherein at least one cell of the N cells (10) or the load output circuit comprises one or more transmission lines (TL).

7. The power combiner circuit of any one of claims 1 to 6, wherein at least one cell of the N cells (10) comprises two or more stacked transistors.

8. The power combiner circuit of any one of claims 1 to 7, wherein the power combiner circuit is configured to provide level shifting to the input signal.

9. A radio frequency amplifier, comprising the power combiner circuit of anyone of claims 1 to 8.

10. A method of operating the power combiner circuit of any one of claims 1 to 8, comprising:
receiving the input signal at the first cell of the N cells (10) of the power combiner circuit,
for each i-th cell, i=1..N-1, of the N cells (10):
providing the first part of the output power of the i-th cell to the load (RL),
providing the second part of the output power of the i-th cell to the i+1-th cell; and providing the output power of the N-th cell (10_N) to the load.

## Patentansprüche

1. Leistungskombiniererschaltung, umfassend:
N Zellen (10), wobei N eine ganze Zahl größer als 1 ist,
wobei jede Zelle der N Zellen mindestens einen Transistor (T₁...T_{N}) umfasst, wobei eine erste Zelle (10_1) der N Zellen (10) konfiguriert ist, um ein Eingangssignal (RF_{IN}) zu empfangen,
wobei jede Zelle, die sich von der N-ten Zelle unterscheidet, konfiguriert ist, um einen ersten Teil ihrer Ausgangsleistung an einen Lastausgangsanschluss der
Leistungskombiniererschaltung und einen zweiten Teil ihrer Ausgangsleistung an eine jeweilige nächste Zelle bereitzustellen, wobei der zweite Teil gleich oder kleiner als der erste Teil ist, und wobei die N-te Zelle (10_N) der N Zellen (10) konfiguriert ist, um ihre Ausgangsleistung an den Lastausgangsanschluss bereitzustellen,
**dadurch gekennzeichnet, dass**
jede Zelle, die sich von der N-ten Zelle unterscheidet, eine erste Primärseite (21; 31) eines ersten Transformators (27) zum Auskoppeln des ersten Teils der Ausgangsleistung und eine zweite Primärseite (22; 32) eines zweiten Transformators (26) zum Auskoppeln des zweiten Teils der Ausgangsleistung umfasst, wobei jede Zelle, die sich von der ersten Zelle unterscheidet, eine zweite Sekundärseite (23; 30) eines jeweiligen zweiten Transformators (26) zum Empfangen des zweiten Teils der Ausgangsleistung von der vorhergehenden Zelle umfasst, wobei die N-te Zelle eine erste Primärseite (24) eines ersten Transformators (27) zum Auskoppeln der Leistung von der N-ten Zelle beinhaltet, wobei die Leistungskombiniererschaltung ferner N erste Sekundärseiten (25) von jeweiligen der ersten Transformatoren (27) umfasst, die in Reihe mit dem Lastausgangsanschluss gekoppelt sind,
wobei die erste Zelle (10_1) konfiguriert ist, um das Eingangssignal an einem Steueranschluss eines ersten Transistors (T₁) des mindestens einen Transistors der ersten Zelle zu empfangen, wobei ein Lastanschluss des ersten Transistors (T₁) des mindestens einen Transistors der ersten Zelle (10_1) mit der ersten Primärseite (21) des ersten Transformators (27) der ersten Zelle (10_1) und mit der zweiten Primärseite (22) des zweiten Transformators (26) der ersten Zelle (10_1) gekoppelt ist, wobei für jede Zelle, die sich von der ersten Zelle unterscheidet, ein erster Lastanschluss des mindestens einen Transistors (T₂...T_{N}) mit der jeweiligen zweiten Sekundärseite (23; 30) der jeweiligen Zelle gekoppelt ist, ein Steueranschluss des mindestens einen Transistors (T₂...T_{N}) konfiguriert ist, um mit einer Vorspannung gekoppelt zu werden, und ein zweiter Lastanschluss des mindestens einen Transistors (T₂...T_{N}) mit der jeweiligen ersten Primärseite der jeweiligen Zelle gekoppelt ist, und für jede Zelle, die sich von der ersten Zelle und der N-ten Zelle unterscheidet, der zweite Lastanschluss des mindestens einen Transistors (T₂...T_{N-1}) ferner mit der jeweiligen zweiten Primärseite der jeweiligen Zelle (10_2...10_N-1) gekoppelt ist.

2. Leistungskombiniererschaltung nach Anspruch 1, wobei die erste und die zweite Primärseite von mindestens einigen der Zellen, die sich von der N-ten Zelle unterscheiden, in Reihe geschaltet sind.

3. Leistungskombiniererschaltung nach Anspruch 1 oder 2, wobei die erste und die zweite Primärseite von mindestens einigen der Zellen, die sich von der N-ten Zelle unterscheiden, parallel geschaltet sind.

4. Leistungskombiniererschaltung, umfassend:
N Zellen (10), wobei N eine ganze Zahl größer als 1 ist,
wobei jede Zelle der N Zellen mindestens einen Transistor (T₁...T_{N}) umfasst, wobei eine erste Zelle (10_1) der N Zellen (10) konfiguriert ist, um ein Eingangssignal (RF_{IN}) zu empfangen,
wobei jede Zelle, die sich von der N-ten Zelle unterscheidet, konfiguriert ist, um einen ersten Teil ihrer Ausgangsleistung an einen Lastausgangsanschluss der
Leistungskombiniererschaltung und einen zweiten Teil ihrer Ausgangsleistung an eine jeweilige nächste Zelle bereitzustellen, wobei der zweite Teil gleich oder kleiner als der erste Teil ist, und wobei die N-te Zelle (10_N) der N Zellen (10) konfiguriert ist, um ihre Ausgangsleistung an den Lastausgangsanschluss bereitzustellen,
**dadurch gekennzeichnet, dass**
jede Zelle der ersten bis N-ten Zelle eine Primärseite (120; 24) eines jeweiligen ersten Transformators (122, 27_2) umfasst, der konfiguriert ist, um die Ausgangsleistung an eine Lastausgangsschaltung (25_1, 121, 25_2) auszukoppeln, die an den Lastausgang gekoppelt ist,
wobei jede Zelle, die sich von der ersten Zelle unterscheidet, eine Sekundärseite (23) eines jeweiligen zweiten Transformators (123) zum Empfangen des jeweiligen zweiten Teils der Leistung von der vorhergehenden Zelle umfasst, wobei die Lastausgangsschaltung N Sekundärseiten (25_1, 25_2) der jeweiligen ersten Transformatoren umfasst, die in einer abwechselnden Weise mit N-1 Primärseiten (121) der jeweiligen zweiten Transformatoren (123) in Reihe gekoppelt sind,
wobei die erste Zelle (10_1) konfiguriert ist, um das Eingangssignal an einem Steueranschluss eines ersten Transistors (T₁) des mindestens einen Transistors der ersten Zelle zu empfangen, wobei ein zweiter Lastanschluss des ersten Transistors (T₁) des mindestens einen Transistors der ersten Zelle (10_1) bis N-ten Zelle (10_N) mit der ersten Primärseite (120; 24) der jeweiligen Zelle (10_1...10N) gekoppelt ist, wobei der Steueranschluss des mindestens einen Transistors jeder Zelle, die sich von der ersten Zelle unterscheidet, konfiguriert ist, um mit einer Vorspannung gekoppelt zu werden, wobei ein erster Lastanschluss des mindestens einen Transistors jeder Zelle, die sich von der ersten Zelle unterscheidet, mit der Sekundärseite (23) der jeweiligen Zelle gekoppelt ist.

5. Leistungskombiniererschaltung nach einem der Ansprüche 1 bis 4, wobei jede Zelle, die sich von der ersten Zelle unterscheidet, konfiguriert ist, um den zweiten Teil der Leistung von den jeweiligen vorhergehenden Zellen an einem ersten Lastanschluss eines ersten Transistors (T₁...T_{N}) des mindestens einen Transistors der jeweiligen Zelle zu empfangen und um den ersten und den zweiten Teil der Leistung an einem zweiten Lastanschluss des ersten Transistors (T₂...T_{N}) oder einem weiteren Transistor des mindestens einen Transistors der jeweiligen Zelle bereitzustellen.

6. Leistungskombiniererschaltung nach einem der Ansprüche 1 bis 5, wobei mindestens eine Zelle der N Zellen (10) oder die Lastausgangsschaltung eine oder mehrere Übertragungsleitungen (TL) umfasst.

7. Leistungskombiniererschaltung nach einem der Ansprüche 1 bis 6, wobei mindestens eine Zelle der N Zellen (10) zwei oder mehr gestapelte Transistoren umfasst.

8. Leistungskombiniererschaltung nach einem der Ansprüche 1 bis 7, wobei die Leistungskombiniererschaltung konfiguriert ist, um eine Pegelverschiebung für das Eingangssignal bereitzustellen.

9. Funkfrequenzverstärker, umfassend die Leistungskombiniererschaltung nach einem der Ansprüche 1 bis 8.

10. Verfahren zum Betreiben der Leistungskombiniererschaltung nach einem der Ansprüche 1 bis 8, umfassend:
Empfangen des Eingangssignals an der ersten Zelle der N Zellen (10) der Leistungskombiniererschaltung,
für jede i-te Zelle, i=1..N-1, der N Zellen (10):
Bereitstellen des ersten Teils der Ausgangsleistung der i-ten Zelle an die Last (RL),
Bereitstellen des zweiten Teils der Ausgangsleistung der i-ten Zelle an die i+1-te Zelle; und
Bereitstellen der Ausgangsleistung der N-ten Zelle (10_N) an die Last.

## Revendications

1. Un circuit de combineur de puissance, comprenant :
N cellules (10), N étant un nombre entier plus grand que 1, chaque cellule des N cellules comprenant au moins un transistor (T₁...T_{N}), dans lequel une première cellule (10_1) des N cellules (10) est configurée pour recevoir un signal (RF_{IN}) d'entrée, dans lequel chaque cellule différente de la N-ième cellule est configurée pour donner une première partie de sa puissance de sortie à une borne de sortie de charge du circuit de combineur de puissance et une deuxième partie de sa puissance de sortie à une cellule suivante respective, dans lequel la deuxième partie est inférieure ou égale à la première partie et dans lequel la N-ième cellule (10_N) des N cellules (10) est configurée pour donner sa puissance de sortie à la borne de sortie de charge,
**caractérisé en ce que**
chaque cellule différente de la N-ième cellule comprend un premier côté (21 ; 31) primaire d'un premier transformateur (27) pour sortir la première partie de la puissance de sortie et un deuxième côté (22 ; 32) primaire d'un deuxième transformateur (26) pour sortir la deuxième partie de la puissance de sortie, dans lequel chaque cellule différente de la première cellule comprend un deuxième côté (23 ; 30) secondaire d'un deuxième transformateur (26) respectif pour recevoir la deuxième partie de la puissance de sortie de la cellule précédente, dans lequel la N-ième cellule comprend un premier côté (24) primaire d'un premier transformateur (27) pour sortir la puissance de la N-ième cellule, dans lequel le circuit de combineur de puissance comprend en outre N premiers côtés (25) secondaires de l'un respectif des premiers transformateurs (27) montés en série avec la borne de sortie de charge,
dans lequel la première cellule (10_1) est configurée pour recevoir le signal d'entrée à une borne de commande d'un premier transistor (T₁) du au moins un transistor de la première cellule, dans lequel une borne de charge du premier transistor (T₁) du au moins un transistor de la première cellule (10_1) est connectée au premier côté (21) primaire du premier transformateur (27) de la première cellule (10_1) et au deuxième côté (22) primaire du deuxième transformateur (26) de la première cellule (10_1), dans lequel, pour chaque cellule différente de la première cellule, une première borne de charge du au moins un transistor (T₂...T_{N}) est connectée au deuxième côté (23 ; 30) secondaire respectif de la cellule respective, une borne de commande du au moins un transistor (T₂...T_{N}) configurée pour qu'il s'y applique une tension de polarisation et une deuxième borne de charge du au moins un transistor (T₂...T_{N}) est connectée au premier côté primaire respectif de la cellule respective et pour chaque cellule différente de la première cellule et de la N-ième cellule, la deuxième borne de charge du au moins un transistor (T₂...T_{N-1}) est connectée en outre au deuxième côté primaire respectif de la cellule (10_2...10_N-1) respective.

2. Le circuit de combineur de puissance de la revendication 1, dans lequel les premier et deuxième côtés primaires d'au moins certaines des cellules différentes de la N-ième cellule sont montés en série.

3. Le circuit de combineur de puissance de la revendication 1 ou 2, dans lequel les premier et deuxième côtés primaires d'au moins certaines des cellules différentes de la N-ième cellule sont montés en parallèle.

4. Un circuit de combineur de puissance, comprenant :
N cellules (10), N étant un nombre entier plus grand que 1, chaque cellule des N cellules comprenant au moins un transistor (T₁...T_{N}), dans lequel une première cellule (10_1) des N cellules (10) est configurée pour recevoir un signal (RF_{IN}) d'entrée, dans lequel chaque cellule différente de la N-ième cellule est configurée pour donner une première partie de sa puissance de sortie à une borne de sortie de charge du circuit de combineur de puissance et une deuxième partie de sa puissance de sortie à une cellule suivante respective, dans lequel la deuxième partie est inférieure ou égale à la première partie et dans lequel la N-ième cellule (10_N) des N cellules (10) est configurée pour donner sa puissance de sortie à la borne de sortie de charge,
**caractérisé en ce que**
chaque cellule de la première à la N-ième cellule comprend un côté (120 ; 24) primaire d'un premier transformateur (122, 27_2) respectif configuré pour envoyer la puissance de sortie à un circuit (25_1, 121, 25_2) de sortie de charge connecté à la sortie de charge, dans lequel chaque cellule différente de la première cellule comprend un côté (23) secondaire d'un deuxième transformateur (123) respectif pour recevoir la deuxième partie respective de la puissance de la cellule précédente, dans lequel le circuit de sortie de charge comprend N côtés (25_1, 25_2) secondaires des premiers transformateurs respectifs montés en série en alternance avec N-1 côtés (121) primaires des deuxièmes transformateurs (123) respectifs, dans lequel la première cellule (10_1) est configurée pour recevoir le signal d'entrée à une borne de commande d'un premier transistor (T₁) du au moins un transistor de la première cellule, dans lequel une deuxième borne de charge du premier transistor (T₁) du au moins un transistor de la première cellule (10_1) à la N-ième cellule (10_N) est connectée au premier côté (120 ; 24) primaire de la cellule (10_1...10N) respective, dans lequel la borne de commande du au moins un transistor de chaque cellule différente de la première cellule est configurée pour qu'une tension de polarisation y soit appliquée, dans lequel une première borne de charge du au moins un transistor de chaque cellule différente de la première cellule est connectée au côté (23) secondaire de la cellule respective.

5. Le circuit de combineur de puissance de l'une quelconque des revendications 1 à 4, dans lequel chaque cellule différente de la première cellule est configurée pour recevoir la deuxième partie de la puissance des cellules précédentes respectives à une première borne de charge d'un premier transistor (T₁...T_{N}) du au moins un transistor de la cellule respective et pour donner la première et la deuxième partie de la puissance à une deuxième borne de charge du premier transistor (T₂...T_{N}) ou à un autre transistor du au moins un transistor de la cellule respective.

6. Le circuit de combineur de puissance de l'une quelconque des revendications 1 à 5, dans lequel au moins une cellule des N cellules (10) ou le circuit de sortie de charge comprend une ou plusieurs lignes (TL) de transmission.

7. Le circuit de combineur de puissance de l'une quelconque des revendications 1 à 6, dans lequel au moins une cellule des N cellules (10) comprend deux ou plusieurs transistors empilés.

8. Le circuit de combineur de puissance de l'une quelconque des revendications 1 à 7, dans lequel le circuit de combineur de puissance est configuré pour donner un décalage de niveau au signal d'entrée.

9. Un amplificateur de fréquence radio, comprenant le circuit combineur de puissance de l'une quelconque des revendications 1 à 8.

10. Un procédé pour faire fonctionner le circuit de combineur de puissance de l'une quelconque des revendications 1 à 8, comprenant :
recevoir le signal d'entrée à la première cellule des N cellules (10) du circuit du combineur de puissance,
pour chaque i-ème cellule, i = 1..N-1, des N cellules (10) :
donner la première partie de la puissance de sortie de la i-ème cellule à la charge (RL),
donner la deuxième partie de la puissance de sortie de la i-ème cellule à la i+1-ième cellule ; et
donner la puissance de sortie de la N-ième cellule (10_N) à la charge.
